# EUROPÄISCHE PATENTSCHRIFT

(11) **EP 3 273 753 B1**
(45) Veröffentlichungstag und Bekanntmachung des Hinweises auf die Patenterteilung: **09.09.2026**
(21) Anmeldenummer: 17182471.7
(22) Anmeldetag: 21.07.2017
(51) Int. Cl.: H05K 1/02, H01R 4/30, H01R 12/52, H05K 1/14, H05K 3/30, H05K 3/36, H01R 4/36

(54) **BAUGRUPPE BESTEHEND AUS ZUMINDEST ZWEI PLATINEN UND ZUMINDEST EINEM GEWINKELTEN UND LEITFÄHIGEN VERBINDUNGSMITTEL**
ASSEMBLY COMPRISING AT LEAST TWO CIRCUIT BOARDS AND AT LEAST ONE ANGLED AND CONDUCTIVE CONNECTING MEANS
ENSEMBLE COMPORTANT AU MOINS DEUX PLATINES ET AU MOINS UN DISPOSITIF DE FIXATION CONDUCTEUR PRÉSENTANT UN ANGLE

(30) Priorität: 22.07.2016 DE 102016213516; 19.07.2017 DE 102017212409
(43) Veröffentlichungstag der Anmeldung: 24.01.2018
(73) Patentinhaber: AUMOVIO Germany GmbH, 60488 Frankfurt am Main (DE)
(72) Erfinder: Staller, Tobias, 78166 Donaueschingen (DE); Breitmoser, Steffen, 78073 Bad Dürrheim (DE)
(74) Vertreter: Aumovio Corporation

(56) Entgegenhaltungen:
- WO-A1-2014/128812
- JP-A- H08 339 848
- JP-U- S5 147 865
- US-A1- 2010 253 155

## Beschreibung

Die Erfindung betrifft eine Baugruppe bestehend aus zumindest zwei Platinen und zumindest einem gewinkelten und leitfähigen Verbindungsmittel für ein elektrisches oder elektronisches Gerät sowie die Verwendung einer Baugruppe mit gewinkeltem Verbindungsmittel, wobei mittels des Verbindungsmittels neben der damit ausgebildeten Verbindung von zumindest zwei Platinen zusätzlich mittels Platine-zu-Platine-Stecker eine Verbindung zwischen den Platinen ausgebildet wird und weiterhin ein Fahrzeugeinbaugerät mit einer Baugruppe aufweisend zumindest zwei Platinen und ein die zwei Platinen verbindendes gewinkeltes Verbindungsmittel.

In vielen Elektronischen Geräten befinden sich mehrere Platinen, die miteinander in Verbindung stehen können.

Es ist üblich, mittels separaten Masseleitern Masseausgleichsverbindungen zwischen verschiedenen Bauteilen oder Baugruppen, aus denen elektrische oder elektronische Geräte aufgebaut sind, zu schaffen. Dabei kommen unter Anderem Steckverbindungen, Klemmverbindungen und Lötverbindungen zum Einsatz. Neben konventionellen Leitungssträngen mit einzelnen Adern in Kabeln kommen auch Flachbandkabel und sogenannte Flexleitungen zum Einsatz. Flexleitungen, d. h. flexible Flachbandleitungen, kann man als miniaturisierte Variante von Flachbandkabeln ansehen, bei denen Metallbändern zwischen flachen, flexiblen und isolierenden Kunststofffilm-Schichten die Leitungsadern darstellen. Daneben ist es auch üblich, insbesondere im Bereich Personal Computer (PC) und ähnlichen bzw. verwandten Feldern, die Masseverbindung von Platinen über Montageschrauben zu realisieren, wenn eine Platine beispielsweise auf einer teilweise metallischen oder anderweitig elektrisch leitfähigen Konstruktion, beispielsweise einer Trägerplatte oder einem Gehäuse, angebracht ist. In dem Fall muss dann sicher gestellt werden, dass diese Trägerplatte oder das Gehäuse dann wiederum eine Massenerdung aufweisen. Weiterhin ist es verbreitet, eine Masseausgleichsverbindung mittels einer oder mehrerer Kontaktfedern zu realisieren.

Bei der Verwendung von mehreren in Verbindung stehenden Platinen ist es verbreitet, die Platinen mittels eines mehrere Kontakte aufweisenden starren Steckers (respektive einer Buchse), welcher üblicherweise auf eine Platine gelötet wird, elektrisch zu verbinden. Dabei kommen die sogenannten Platine-zu-Platine-Stecker (auch "board-to-board" - Stecker) zum Einsatz. Jedoch sind Verbindungen mit solchen Steckern anfällig für Vibrationen, sodass beim Einsatz von Geräten in einem vibrationsintensiven Umfeld häufig derartige Steckverbindungen die erste Ursache für Defekte sind. Dementsprechend können derartige Steckverbindungen einen negativen Effekt beispielsweise auf die Langlebigkeit von Geräten haben.

Bei der Verwendung von mehreren in Verbindung stehenden Platinen ist es alternativ üblich, die Platinen mittels eines oder mehrerer flexiblen Leiter elektrisch zu verbinden. Hier kommen beispielsweise Flachbandkabel und Flexleitungen zum Einsatz. Derartige Leiter sind zwar weniger anfällig für Vibrationen, als eine Verbindung mittels Platine-zu-Platine-Stecker, aber dafür auch keinerlei mechanische Verbindung und andere Nachteile.

Zum Schutz vor elektrostatischen Überschlägen (ESD-Schutz) können dann Kontakte der Platine-zu-Platine-Stecker oder Adern von Flachbandkabeln oder Flexleitungen eingesetzt werden, um einen Massenausgleich zwischen den beteiligten Platinen zu gewährleisten. Dabei ist es wünschenswert, dass die für den ESD-Schutz verwendeten Leiter einen möglichst geringen elektrischen Widerstand haben. Jedoch bietet die Verwendung von Kontakten von Platine-zu-Platine-Steckern und insbesondere von Adern von Flachbandkabeln oder Flexleitungen typischerweise keinen ausreichenden ESD-Schutz oder den gewünscht niedrigen elektrischen Widerstand.

Üblicherweise werden in Geräten, die mit mehreren Platinen ausgestattet sind, die beteiligten Platinen individuell und separat mechanisch an einer Tragekonstruktion, beispielsweise an einem Gerätegehäuse, angebracht, wobei beispielsweise Schraubverbindungen oder auch Klemmverbindungen genutzt werden.

Platine-zu-Platine-Stecker, Flachbandkabel und insbesondere Flexleitungen weisen üblicherweise (ihrer kompakten Bauform nach) geringe Leitungsquerschnitte auf, sodass selbst die Verwendung mehrerer Adern zum Zweck des Massenausgleichs / ESD-Schutzes noch zu unbefriedigenden Ergebnissen führen kann.

Andererseits kann eine Verbindung zwischen Platinen mittels flexiblen Adern, Flachbandkabeln, Flexleitungen oder Kontaktfedern die beteiligten Platinen oder Geräte nicht gegenüber mechanischen Belastungen wie Vibrationen, Erschütterungen, Stößen oder Verformung schützen. Verbindungen mittels Platine-zu-Platine-Stecker schützen nicht nur nicht vor mechanischen Belastungen, sondern sind vielmehr selbst besonders anfällig für durch derartige Belastungen verursachte Schäden.

Die JP H08 339848 A zeigt zwei Leiterplatten, die orthogonal miteinander verbunden und fixiert sind, wobei eine Leiterplatte vorgesehen ist, die aus einem leitenden Metall besteht und die Leiterplatten mechanisch verbindet und fixiert und die Signalleitungen zwischen den Leiterplatten zumindest elektrisch verbindet.

Ferner zeigt die WO 2014/128812 A1 einen Verbindungsaufbau für eine erste und eine zweite Leiterplatte, die senkrecht zueinander angeordnet und elektrisch miteinander verbunden und in einem Gehäuse befestigt sind. Eine elektrische Verdrahtung der ersten Leiterplatte und eine elektrische Verdrahtung der zweiten Leiterplatte sind über Steckverbinder verbunden. Beide Leiterplatten sind mit einem L-förmigen Beschlag in der Nähe eines Steckeranschlussteils beider Leiterplatten befestigt.

Außerdem zeigt JP S51 47865 U eine Anordnung mit einer ersten und einer zweiten Leiterplatte.

Ferner zeigt US 2010/253155 A1 eine Struktur zur Übertragung in einer Stromversorgung. Es ist eine Stromübertragungsplatine zum Anordnen eines Stromeingangsanschlusses vorgesehen, wobei die Stromübertragungsplatine über ein Stromleitungselement elektrisch mit einer Stromverarbeitungsplatine verbunden ist.

Die Aufgabe der Erfindung ist daher, eine verbesserte Möglichkeit zur Verbindung von zumindest zwei Platinen bereitzustellen.

Diese Aufgabe wird durch eine Baugruppe bestehend aus zumindest zwei Platinen und zumindest einem gewinkelten und leitfähigen Verbindungsmittel gemäß Anspruch 1, eine Verwendung gemäß Anspruch 13 sowie ein Fahrzeugeinbaugerät gemäß Anspruch 14 gelöst. Ausgestaltungen und Weiterbildungen des Erfindungsgedankens sind Gegenstand von abhängigen Ansprüchen.

Es werden eine Baugruppe bestehend aus zumindest zwei Platinen und zumindest einem gewinkelten und leitfähigen Verbindungsmittel sowie die Verwendung eines solchen zusammen mit einem Platine-zu-Platine-Stecker und die Verwendung einer solchen Baugruppe in einem Fahrzeugeinbaugerät offenbart.

Damit wird durch eine Baugruppe bestehend aus zumindest zwei Platinen und zumindest einem gewinkelten und leitfähigen Verbindungsmittel zugleich eine verbesserte ESD-Schutz und eine mechanische Positionierung sowie Fixierung erreicht.

In einer erfindungsgemäßen Baugruppe bestehend aus zumindest zwei Platinen und zumindest einem gewinkelten und leitfähigen Verbindungsmittel (100) für ein elektrisches oder elektronisches Gerät, bildet das Verbindungsmittel eine elektrischen Verbindung oder galvanischen Brücke der zumindest zwei Platinen und zugleich einer mechanischen Verbindung dieser Platinen in der Baugruppe aus, wobei das Verbindungsmittel zumindest zwei zueinander in einem Winkel stehende Schenkel aufweist und eine erste Platine an der Außenseite eines ersten Schenkels angeordnet ist und eine zweite Platine an der Innenseite eines zweiten Schenkels angeordnet ist und wobei der Winkel dieser zwei Platinen zueinander dem Winkel des ersten Schenkels des Verbindungsmittels zum zweiten Schenkel des Verbindungsmittels entspricht.

Um die Platinen besonders zu verbinden, ist zumindest ein Schenkel des gewinkelten Verbindungsmittels mittels einer Lötverbindung mit der an diesem Schenkel angeordneten Platine verbunden. Ferner ist zumindest ein Schenkel des gewinkelten Verbindungsmittels mit der an diesem Schenkel angeordneten Platine verschraubt.

Bei der Baugruppe, bestehend aus zumindest zwei Platinen und zumindest einem gewinkelten und leitfähigen Verbindungsmittel, ist zumindest ein Schenkel des gewinkelten Verbindungsmittels mittels einer Lötverbindung mit der an diesem Schenkel angeordneten Platine verbunden. Besondere Vorteile einer Lötverbindung sind unter anderem der gute und sichere elektrische Kontakt, damit einhergehend ein geringer elektrischer Widerstand respektive ein hoher elektrischer Leitwert und gute prozesstechnische Handhabbarkeit.

Bei der Baugruppe, bestehend aus zumindest zwei Platinen und zumindest einem gewinkelten und leitfähigen Verbindungsmittel, ist zumindest einer der Schenkel des Verbindungsmittels mit der an diesem Schenkel angeordneten Platine verschraubt. Hierbei liegen besondere Vorteile in der Reversibilität der Verbindung, in der Stabilität der mechanischen Verbindung und in der erprobten Technik.

Bei der Verwendung einer Baugruppe mit gewinkeltem Verbindungsmittel wird mittels des Verbindungsmittels neben der damit ausgebildeten Verbindung von zumindest zwei Platinen zusätzlich mittels Platine-zu-Platine-Stecker eine Verbindung zwischen zumindest zwei der Platinen ausgebildet.

Ein erfindungsgemäßes Fahrzeugeinbaugerät weist eine Baugruppe nach Anspruch 1 auf.

Besondere Ausführungsformen sind Gegenstand der Unteransprüche.

In einer einfachen beispielhaften Ausführungsform ist ein erfindungsgemäßes gewinkeltes und leitfähiges Verbindungsmittel zur Ausbildung einer elektrischen Verbindung in einer Baugruppe mit zumindest zwei Platinen im Wesentlichen ein flächiges Erzeugnis, das zumindest zwei plattenartige Bestandteile mit planen Oberflächen aufweist, welche miteinander fest verbunden sind und in einem Winkel zueinander stehen. Da die beiden plattenartigen Bestandteile in einem Winkel zueinander stehen, ist somit auch das Verbindungsmittel insgesamt gewinkelt. Ein geometrischer Winkel kann durch seine beiden Schenkel definiert werden. Daraus abgeleitet kann man die zwei zueinander in einem Winkel stehenden wesentlichen Bestandteile, die in diesem beispielhaften Fall plattenartig gestaltet sind, als die zwei Schenkel des erfindungsgemäßen gewinkelten und leitfähigen Verbindungsmittels bezeichnen. Die beiden Schenkel sind so geartet, dass zumindest mit jeweils einem Schenkel jeweils eine Platine zur Verbindung gebracht werden kann. Infolgedessen wird die Anordnung der Platinen im Winkel relativ zueinander von der Form des erfindungsgemäßen Verbindungsmittels vorgegeben. Auch im Fall von einer von einer einfachen Fläche abweichenden Formgestaltung der Bereiche eines erfindungsgemäßen Verbindungsmittels, die jeweils mit einer Platine in Verbindung stehen und dadurch die Anordnung der Platinen relativ zueinander vorgeben, kann man diese verschiedenen Bereiche als Schenkel bezeichnen.

Unter einer Platine kann man auch eine Leiterplatte oder eine gedruckte Schaltung (Nach dem Englischen Begriff "printed circuit board" auch mit PCB abgekürzt) oder andere flächige Elektronikträger verstehen.

Als Kontaktierungsbereich wird ein Bereich auf der Oberfläche einer Platine bezeichnet, in dem ein elektrischer Kontakt zwischen der Platine und einem anderen elektrischen oder elektronischen Bauteil hergestellt werden kann. Ein Kontaktierungsbereich wird gezielt bereitgestellt, um einen elektrischen Kontakt herstellen zu können. Ein elektrischer Kontakt kann beispielsweise durch Löten oder Klemmen oder Bonden oder Schweißen oder Kleben hergestellt werden. Ein zeitweiser Kontakt kann aber auch beispielsweise mittels eines Nadelkontakts oder einer Mess-Sonde oder Mess-Spitze hergestellt werden. Ein Kontaktierungsbereich kann auch als Kontaktpad oder Lötpad bezeichnet werden. Im Kontaktierungsbereich einer Platine kann beispielsweise auch ein elektrischer Kontakt mit einem gewinkelten und leitfähigen Verbindungsmittel hergestellt werden.

Eine Verwendung eines erfindungsgemäßen gewinkelten und leitfähigen Verbindungsmittels in einer Baugruppe mit zumindest zwei Platinen kann beispielsweise besonders vorteilhaft im Bereich Kraftfahrzeug-Technik (kurz KFZ-Technik, auch als Automotive-Bereich bezeichnet) erfolgen. In der KFZ-Technik gelten besondere Anforderungen, beispielsweise auch an die zu verwendenden elektrischen und elektronischen Geräte. So sind beispielsweise eine besondere Robustheit gegenüber starken Vibrationen, großen Temperaturschwankungen (-40°C bis +125°C) sowie damit einhergehenden mechanischen Ausdehnungen und hoher Luftfeuchtigkeit aber auch Langlebigkeit gefordert.

Bei der Erfindung wird mittels eines erfindungsgemäßen gewinkelten und leitfähigen Verbindungsmittels zwischen zwei Platinen eine Verbindung geschaffen. In einem beispielhaften Ausführungsbeispiel wird das Verbindungselement mit einer ersten Platine verlötet, beispielsweise mittels Löten im Reflow-Verfahren, und mit einer zweiten Platine, die zur ersten Platine in einem Winkel von 90° angeordnet ist, verschraubt. Hierbei wird die zweite Platine beispielsweise durch den Kopf einer gewindefurchenden Schraube, die durch eine Ausnehmung, beispielsweise eine Bohrung, in der zweiten Platine hindurch in das erfindungsgemäße Verbindungselement eingeschraubt wird, an einer Fläche des Verbindungselementes angebracht und fixiert.

In einem beispielhaften Ausführungsbeispiel werden eine erste Platine, die eine Anzeigeeinrichtung, beispielsweise ein Flüssigkristall-Anzeigeelement (auch als LC-Display bezeichnet), trägt, und eine weitere Platine mittels eines erfindungsgemäßen gewinkelten und leitfähigen Verbindungsmittels verbunden. Eine solche Anordnung kann in diversen Geräten nützlich sein, bei denen beispielsweis die eine Anzeige tragende Platine aus der Sicht eines Betrachters vertikal im Gerät verbaut ist, während eine weitere Platine in dem Gerät aus der Sicht eines Betrachters horizontal, beispielsweise planparallel zu einer Gehäuse-Bodenplatte des Gerätes, eingebaut sein kann.

In einem beispielhaften Ausführungsbeispiel ist ein erfindungsgemäßes gewinkeltes und leitfähiges Verbindungsmittel in einer Baugruppe mit zumindest zwei Platinen aus einem Metallblech, d. h. aus einer z. B. durch Walzen in Form gebrachten, flachen Metallplatte, hergestellt. Der Werkstoff kann dabei beispielsweise ein Stahl sein. Ein Vorteil der Herstellung derartiger erfindungsgemäßer gewinkelter Verbindungselemente ist beispielsweise eine besonders kostengünstige Herstellung mit geringem Zeitaufwand. Beispielsweise kann in einem ersten Schritt ein Stück aus dem Blech ausgeschnitten und dann mit den gewünschten Ausnehmungen, beispielsweise Bohrungen und/oder Stanzlöchern, versehen werden sowie durch ein umformendes Verfahren in die gewünschte gewinkelte Form gebracht werden.

In einem beispielhaften Ausführungsbeispiel weisen die Schenkel eines gewinkelten und leitfähigen Verbindungsmittels in einer Baugruppe mit zumindest zwei Platinen Ausnehmungen, beispielsweise Bohrungen, zur Ausbildung von Lötverbindungen mit Lotmenisken in den Ausnehmungen auf. Weiterhin kann beispielsweise mit einer erhöhten Anzahl von Ausnehmungen die verbindungsschaffende Fläche vergrößert werden und eine besonders robuste mechanische Verbindung zwischen Platinen und gewinkeltem Verbindungselement herstellt werden. In einem Umfeld mit besonders hohen Anforderungen an die mechanische Robustheit der Verbindung kann eine derartige Ausführungsform besonders vorteilhaft sein.

In einem beispielhaften Ausführungsbeispiel weist ein Schenkel eines gewinkelten und leitfähigen Verbindungsmittels in einer Baugruppe mit zumindest zwei Platinen, der zumindest eine Ausnehmung, beispielsweise eine Bohrung, zur Ausbildung einer Lötverbindung mit Lotmeniskus aufweist, überdies eine Ausnehmung zur Ausbildung einer Schraubverbindung auf. Dabei kann es sich beispielsweise um eine zylindrische Bohrung, durch die eine Schraube in einen hinter dem Verbindungsmittel liegenden Körper geschraubt wird, handeln. Es kann sich aber auch um eine Bohrung mit Innengewinde oder eine andere Bohrung oder eine andere Ausnehmung handeln.

In einem beispielhaften Ausführungsbeispiel wird ein erfindungsgemäßes gewinkeltes Verbindungsmittel in einer Baugruppe mit zumindest zwei Platinen mittels Nieten mit einer Platine zur Verbindung gebracht.

In einem weiteren beispielhaften Ausführungsbeispiel wird ein erfindungsgemäßes gewinkeltes Verbindungsmittel in einer Baugruppe mit zumindest zwei Platinen mittels Kleben mit einer Platine zur Verbindung gebracht. Dabei sind sowohl leitfähige als auch nicht-leitfähige Klebemittel denkbar.

In einem beispielhaften Ausführungsbeispiel ist eine Baugruppe bestehend aus zumindest zwei Platinen und zumindest einem gewinkelten und leitfähigen Verbindungsmittel Bestandteil eines Fahrzeugeinbaugerätes. Besonders vorteilhaft kann hierbei beispielsweise eine der Platinen die Hauptplatine sein und eine zweite Platine kann beispielsweise ein Anzeigeelement tragen. Eine Konstellation aus Hauptplatine und Anzeigeplatine stellt eine übliche Variante eines typischen Geräteaufbaus dar, aber die erfindungsgemäße Baugruppe ist keineswegs auf diesen beispielhaften Fall beschränkt zu sehen. Beliebige Konstellationen von Platinen sind in Zusammenhang mit der Erfindung denkbar. Beispielsweise könnte eine der Platinen, die in einer beispielhaften Baugruppe verbunden werden, auch eine Erweiterungskarte oder eine nebengelagerte Recheneinheit oder eine Speicherkarte oder eine Schnittstellenkarte oder eine Kommunikationskarte oder eine Verschlüsselungskarte oder eine Steuerungskarte oder eine Kommunikations-Master-Karte sein.

Bei der erfindungsgemäßen Baugruppe erfolgt mittels des gewinkelten Verbindungsmittels zusätzlich eine Positionierung der Platinen relativ zueinander und eine Fixierung der sich so ergebenden Positionen der Platinen. Auf diese Weise kann in besonders vorteilhafter Weise auch eine starre mechanische Verbindung hergestellt werden. Es ist besonders ökonomisch, wenn die Gestaltung des Verbindungselementes derart ist, dass die Verbindung der Platinen mit einer Positionierung einhergeht.

Bei einer besonders vorteilhaften Ausführungsform besteht ein gewinkeltes Verbindungsmittel in einer Baugruppe mit zumindest zwei Platinen aus einem metallischen Material, vorzugsweise aus Stahl. Besondere Vorteile metallischer Werkstoffe sind geringer elektrischer Widerstand (oder in anderen Worten: Ein guter elektrischer Leitwert), Stabilität und Robustheit, breite Verfügbarkeit und, in Bezug auf die Verarbeitungsweisen metallischer Werkstoffe, ein hoher verfügbarer Kenntnisstand.

In einer besonders vorteilhaften Ausführung ist eine Baugruppe bestehend aus zumindest zwei Platinen und zumindest einem gewinkelten und leitfähigen Verbindungsmittel so gestaltet, dass die zumindest zwei Platinen damit in einem Winkel von 90° zueinander angeordnet werden. Besondere Vorteile einer Anordnung im rechten Winkel ergeben sich beispielsweise beim Einsatz in quaderförmigen Gerätegehäusen.

In einer besonderen Ausführungsform einer Baugruppe bestehend aus zumindest zwei Platinen und zumindest einem gewinkelten und leitfähigen Verbindungsmittel ist zumindest einer der beiden Schenkel des Verbindungsmittels derart mittels einer Lötverbindung mit der an diesem Schenkel angeordneten Platine in Verbindung gebracht, dass der Schenkel zumindest eine Ausnehmung aufweist, durch die in einem Lötvorgang eingebrachtes Lötzinn aufsteigen kann. Ein besonderer Vorteil dieser Ausführungsform liegt darin, dass sich an den Mantelflächen der Ausnehmungen, beispielsweise Bohrungen, Lot-Menisken bilden. Das Erzeugen und die Qualität einer auf diese Weise geschaffenen, dauerhaft leitfähigen Verbindung lässt sich leicht, beispielsweise mittels einer optischen Prüfmethode oder mittels Sichtkontrolle, überprüfen. Weiterhin vorteilhaft ist an dieser Ausführungsform, dass gegenüber einem flächigen Verlöten eines Schenkels ohne Bohrungen auf einer Platine die Fläche des Kontaktpads auf der Platine verringert werden kann: Für ein flächiges Verlöten beispielsweise eines Schenkels auf einer Platine wird ein Kontaktpad benötigt, dessen Fläche größer ist als die des zu verlötenden Schenkels: Üblicherweise muss die Ausdehnung des Pads in allen Richtungen um 0,5 mm über die anliegende Kontaktfläche eines flächig darauf zu verlötenden Bauteils herausragen, damit sich an den zum Kontaktpad senkrechten Außenflächen des Schenkels zum Kontaktpad hin Lotmenisken bilden können. Die hier beschriebene Ausführungsform mit Ausnehmungen ermöglicht hingegen die Ausbildung von Lotmenisken in den Bohrungen, sodass die Fläche des Kontaktpads verringert werden kann. Ein weiterer besonderer Vorteil dieser Ausführungsform liegt darin, dass die Position des Schenkels gegenüber der Platine beim Lötvorgang besonders genau gesteuert werden kann. In anderen Worten ermöglicht diese Ausführungsform besonders vorteilhaft den unerwünschten Effekt, dass sich nach einem Lötvorgang ein zu verlötendes Bauteil nicht mehr an der gewünschten Position befindet (auch "Verschwimmen" genannt), zu verringern. Auch Ausführungsformen mit mehreren Bohrungen und Ausführungsformen mit Ausnehmungen in verschieden Formen sind vorstellbar.

Bei der erfindungsgemäßen Baugruppe ist die Formgebung des Verbindungsmittels derart gestaltet, dass die an der Innenseite des einen Schenkels angeordnete Platine in den Scheitelpunkt des Winkels des Verbindungsmittels ragt. Besondere Vorteile sind hier eine besonders kompakte Gestaltung der Anordnung, eine gute Raumausnutzung und infolge der Kompaktheit eine erhöhte mechanische Stabilität.

In einer besonders vorteilhaften Ausführungsform einer Baugruppe bestehend aus zumindest zwei Platinen und zumindest einem gewinkelten und leitfähigen Verbindungsmittel ist die Formgebung des Verbindungsmittels derart gestaltet, dass die Schnittgerade der zwei Flächen, die auf den innenseitigen Oberflächen der beiden Schenkel des Verbindungsmittels liegen, außerhalb des Körpers des Verbindungsmittels liegt oder an der Außenseite der Oberfläche des Verbindungsmittels tangierend anliegt.

Bei einer besonders vorteilhaften Ausführungsform weist ein gewinkeltes Verbindungsmittel in einer Baugruppe mit zumindest zwei Platinen zumindest eine kegelförmig zulaufende Öffnung zur Aufnahme eines Gewindes einer Schraube auf. Besondere Vorteile einer derartigen Ausführungsform liegen darin, dass eine kegelförmig zulaufende Öffnung einerseits mehr Kontaktfläche für eine Schraube zur Ausbildung einer Schraubverbindung bieten kann. Andererseits lassen sich kegelförmig zulaufende Öffnungen besonders wirtschaftlich, beispielsweise durch Stanzen, herstellen. Wiederum besonders günstig ist die Verwendung einer selbstfurchenden oder selbstschneidenden Schraube zur Ausbildung der Schraubverbindung, da somit keine weiteren Handhabungsschritte (wie beispielsweise Gewindeschneiden) an der kegelförmig zulaufenden Öffnung erforderlich sind. Anstelle einer kegelförmig zulaufenden Öffnung ist auch eine kragenförmig gestaltete Öffnung denkbar.

In einer besonderen Ausführungsform einer Baugruppe bestehend aus zumindest zwei Platinen und zumindest einem gewinkelten und leitfähigen Verbindungsmittel weist zumindest ein Schenkel des gewinkelten Verbindungsmittels an seinem dem Scheitelpunkt des Winkels fernen Ende einen gegenüber dem scheitelnahen Anteil abgeschrägten Anteil auf. Dadurch wird besonders vorteilhaft eine Vereinfachung bei der Anordnung einer Platine an dem abgeschrägten Schenkel ermöglicht, indem die Schräge als Führung für die Platine fungiert.

In einer besonderen Ausführungsform einer Baugruppe bestehend aus zumindest zwei Platinen und zumindest einem gewinkelten und leitfähigen Verbindungsmittel weist zumindest ein Schenkel des gewinkelten Verbindungsmittels an seinem dem Scheitelpunkt des Winkels fernen Ende einen derart gegenüber dem scheitelnahen Anteil abgeschrägten Anteil auf, dass der abgeschrägte Anteil mit dem anderen Schenkel einen größeren Innenwinkel bildet, als der nicht abgeschrägte Anteil des Schenkels mit dem anderen Schenkel.

Ein besonderer Vorteil dieser Ausführungsform ist die durch das abgeschrägte Ende gewährleistete Erleichterung bei dem Positionieren und/oder Anbringen einer Platine an dem Schenkel mit abgeschrägtem Ende. Insbesondere falls in einem Montagevorgang bereits an dem einen Schenkel eine Platine angebracht ist und sich der Verbund aus Platine und gewinkeltem Verbindungsmittel beispielsweise bereits in eingeschränkten räumlichen Verhältnissen, beispielsweise im Inneren eines Gehäuseteils, in das die Platinen und das Verbindungsmittel eingebaut werden sollen, befindet, kann ein abgeschrägter Anteil eines Schenkels besonders vorteilhaft die Positionierung einer zweiten Platine an diesem Schenkel eines gewinkelten Verbindungsmittels ermöglichen. Beispielsweise kann es in einem besonderen Ausführungsbeispiel wünschenswert sein, zunächst eine mit einem beispielsweise im Wesentlichen quaderförmigen Flüssigkristall-Anzeigeelement ausgestattete Platine an dem in diesem Fall vertikal angeordneten ersten Schenkel eines erfindungsgemäßen gewinkelten Verbindungselementes anzubringen und diesen beispielhaften Verbund aus Verbindungselement und Platine in einem Gehäuse-Bestandteil eines Gerätes, beispielsweise einer Frontblende, anzubringen. In diesem beispielhaften Ausführungsbeispiel könnte dann die Positionierung und Montage einer zweiten Platine an dem in diesem Fall horizontalen, noch freien zweiten Schenkel des Verbindungsmittels in den in diesem Beispiel beengten räumlichen Verhältnissen durch einen abgeschrägten Anteil an dem noch freien Schenkel erleichtert werden. In diesem Ausführungsbeispiel ist beispielsweise die Abschrägung des horizontalen Schenkels so gestaltet, dass an dem Scheitel des Winkels fernen Ende mehr Raum für die Positionierung einer zweiten Platine vorhanden ist.

In einer besonderen Ausführungsform einer Baugruppe bestehend aus zumindest zwei Platinen und zumindest einem gewinkelten und leitfähigen Verbindungsmittel ist das gewinkelte Verbindungsmittel so gestaltet, dass die Flächennormalen zumindest zweier Schenkel windschief sind. Besondere Vorteile liegen hierbei darin, dass eine Vielzahl räumlicher Orientierungen der Platinen zueinander ermöglicht ist.

Bei einer besonders vorteilhaften Ausführungsform weist ein gewinkeltes Verbindungsmittel in einer Baugruppe mit zumindest zwei Platinen mehr als zwei Schenkel auf. Dadurch können besonders vorteilhaft mehr als zwei Platinen mit dem Verbindungsmittel verbunden werden oder es können auch andere Elemente, bei denen es sich nicht um Platinen handelt, mit dem Verbindungsmittel verbunden werden. Es können andere elektrische oder elektronische Komponenten aber auch strukturelle Elemente wie Träger oder Gehäuseteile mit einem Verbindungsmittel verbunden werden.

In einer besonderen Ausführungsform einer Baugruppe mit zumindest zwei Platinen kommt eine gewinkeltes Verbindungsmittel zur Verwendung, wobei neben der mittels des Verbindungsmittels ausgebildeten Verbindung von zumindest zwei Platinen zusätzlich mittels Platine-zu-Platine-Stecker ("board-to-board" - Stecker) eine Verbindung zwischen zumindest zwei der Platinen ausgebildet ist. Dabei vermittelt das erfindungsgemäße Verbindungsmittel zugleich einen Massenausgleich zwischen den Platinen (und damit auch einen besonders effektiven ESD-Schutz) und eine robuste mechanische Verbindung, womit besonders vorteilhaft die Lebensdauer der Platine-zu-Platine-Stecker-Verbindung erhöht wird, indem unter Anderem deren Anfälligkeit für Vibrationen durch ein erfindungsgemäßes Verbindungsmittel herabgesetzt wird.

In einer besonders vorteilhaften Ausführungsform kommt eine Baugruppe bestehend aus zumindest zwei Platinen und zumindest einem gewinkelten und leitfähigen Verbindungsmittel in einem Fahrzeugeinbaugerät zum Einsatz. Besondere Vorteile ergeben sich bei der Verwendung eines gewinkelten Verbindungsmittels im Bereich der KFZ-Technik durch die Vermittlung eines guten ESD-Schutzes und einer hohen Robustheit gegenüber Vibrationen. Besonders geeignet ist die erfindungsgemäße Baugruppe bestehend aus zumindest zwei Platinen und zumindest einem gewinkelten und leitfähigen Verbindungsmittel für eine Verwendung in einem Fahrtenschreiber oder Tachograph. Das Fahrzeug-einbaugerät mit einer erfindungsgemäßen Baugruppe ist daher bevorzugt ein Fahrtenschreiber. Die besonderen Vorteile einer erfindungsgemäßen Baugruppe kommen aber in anderen Fahrzeugeinbaugeräten ebenso zum Tragen. Beispielhaft seien hier fahrzeugseitige Mautgeräten oder Taxameter genannt, ohne die erfindungsgemäße Baugruppe dadurch zu beschränken.

Bei einer besonders vorteilhaften Ausführungsform einer Baugruppe bestehend aus zumindest zwei Platinen und zumindest einem gewinkelten und leitfähigen Verbindungsmittel weist das Verbindungsmittel an zumindest einem Schenkel zumindest eine aus einer Ebene des Schenkels herausragende hohle Ausformung oder Ausstülpung derart auf, dass das Material des Verbindungsmittels das leere Volumen der hohlen Ausformung oder Ausstülpung als Wandung umgibt, wobei die Ausformung oder Ausstülpung eine Schraube aufnimmt, mit der das gewinkelte Verbindungsmittel mit einer der Platinen verschraubt ist. Dadurch wird besonders vorteilhaft ermöglicht, dass beim Verschrauben entstehende Späne nicht aus dem von der Ausformung oder Ausstülpung begrenzten Volumen austreten. Somit werden solche Späne zurückgehalten. Durch das Zurückhalten von Spänen kann verhindert werden, dass andere Bauteile durch das Austreten von Spänen Schaden nehmen.

Bei einer besonders vorteilhaften Ausführungsform einer Baugruppe bestehend aus zumindest zwei Platinen und zumindest einem gewinkelten und leitfähigen Verbindungsmittel mit einer Ausformung oder Ausstülpung weist die Ausformung oder Ausstülpung eine im Wesentlichen zylindrische oder konische Form auf oder ist von topfförmiger Gestalt. Dadurch wird besonders vorteilhaft ermöglicht, die Form der Ausstülpung auf die Gestaltung der dort einzuschraubenden Schraube anzupassen. Weitere Vorteile liegen darin, dass diese Formgestaltungen eine einfachere Herstellung ermöglichen und/oder sparsam in Hinsicht auf den Platzbedarf sind.

Bei einer weiteren besonders vorteilhaften Ausführungsform einer Baugruppe bestehend aus zumindest zwei Platinen und zumindest einem gewinkelten und leitfähigen Verbindungsmittel mit einer Ausformung oder Ausstülpung ist die Ausformung oder Ausstülpung rotationssymmetrisch um eine Symmetrieachse, welche senkrecht auf einer Fläche des Schenkels des Verbindungsmittels steht, an dem die Ausformung oder Ausstülpung angeordnet ist, derart geformt, dass ein Querschnitt der Ausformung (360) der Ausstülpung (360) in einer Ebene senkrecht zu einer Flächenebene eines Schenkels (200; 300) des Verbindungsmittels (100) im Wesentlichen trapezförmig ist, wobei sich die Verjüngung der Trapezform vorzugsweise auf der dem Schenkel abgewandten Seite der Ausformung oder Ausstülpung befindet.

Beim Ausbilden einer Schraubverbindung, d. h. beim Eindrehen einer Schraube, beispielsweise in ein gewinkeltes Verbindungsmittel, können metallische Späne entstehen. Solche Späne können aus dem Bereich der Schraubverbindung austreten. Späne sind unerwünscht, weil sie beispielsweise durch ihre elektrische Leitfähigkeit ungewollte elektrische Verbindungen aufbauen oder durch ihre zumeist scharfen Kanten mechanische Schäden verursachen können. Generell sind solche Späne auch in Gehäusen unerwünscht, da sie selbst in dem Fall, dass sie keinen Schaden verursachen, eine Verunreinigung eines Gehäuses, beispielsweise eines Gerätes, darstellen. Im Fall, dass durch Späne eine ungewollte elektrische Verbindung aufgebaut wird, kann es zum Ausfall von elektrischen und elektronischen Komponenten kommt. Mit einer hohlen Ausformung oder Ausstülpung, welche aus einem Schenkel eines erfindungsgemäßen Verbindungsmittels herausragt, lassen sich Schraubverbindungen herstellen, welche keine Späne absondern, indem die Ausformung so gestaltet wird, dass sie eine Schraube einer Schraubverbindung komplett umgibt. Wenn beim Einschrauben der Schraube dennoch Späne entstehen, werden Sie im Inneren der Ausformung oder Ausstülpung verbleiben. In anderen Worten ist eine Schraube, die zum Ausbilden einer Schraubverbindung in eine hohle Ausformung oder Ausstülpung an einem Schenkel eines gewinkelten Verbindungsmittels geschraubt ist, durch die Ausformung oder Ausstülpung gekapselt, wo die Ausformung oder Ausstülpung die Schraube umgibt. Dadurch können Schraubverbindungen ohne das Risiko, dass metallische Späne entstehen, geschaffen werden.

Die Erfindung wird nachfolgend anhand der Figuren der Zeichnung näher erläutert, wobei gleiche oder ähnliche Elemente mit denselben Bezugszeichen versehen sind. Es zeigt:
- Figur 1: in einer isometrischen Darstellung ein gewinkeltes und leitfähiges Verbindungsmittel,
- Figur 2: in einer Schnittzeichnung das gewinkelte und leitfähige Verbindungsmittel nach Figur 1,
- Figur 3: als Schnittzeichnungen das gewinkelte und leitfähige Verbindungsmittel, unterteilt in Teilfiguren Figur 3a und Figur 3b, in einer Variante mit einer Ausnehmung zur Ausbildung einer Schraubverbindung und in einer Variante mit einer Ausformung oder einer Ausstülpung zur Ausbildung einer Schraubverbindung.

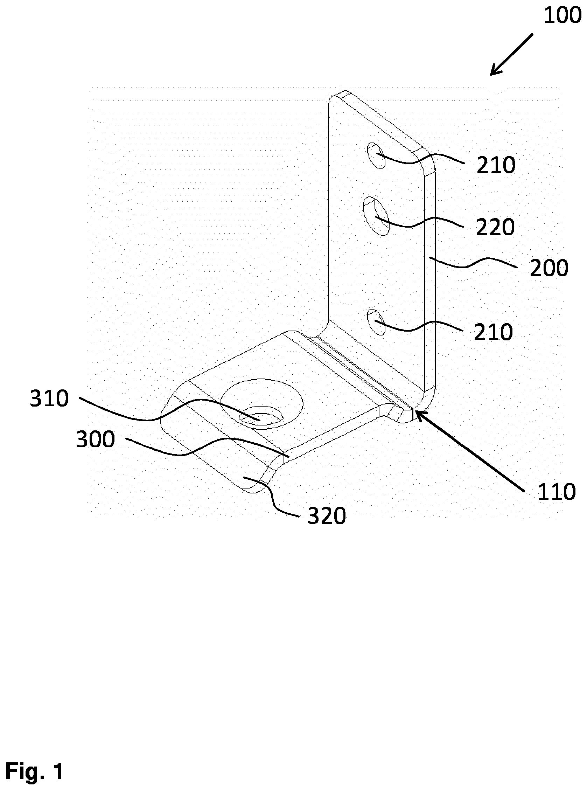

Figur 1 zeigt in einer isometrischen Darstellung eine beispielhafte Ausführung eines gewinkelten und leitfähigen Verbindungsmittels 100 mit einer beispielhaften besonders vorteilhaften Formgebung im Scheitelbereich 110 des Winkels. Im gezeigten Fall ist die besonders vorteilhafte Formgebung im Scheitelbereich 110 des Winkels dadurch gegeben, dass der Radius im Scheitelbereich des Winkels des Verbindungsmittels, beispielsweise durch Biegen oder Tiefziehen erzeugt, gegenüber der Ebene des Schenkels, an dessen Innenseite eine Platine angeordnet wird, nach außen versetzt, sodass bis zum Scheitelpunkt des Winkels Platz für die innenseitig angeordnete Platine vorhanden ist. Ein erster Schenkel 200 weist Ausnehmungen zur Ausbildungen von Lötverbindungen 210 und eine Ausnehmung zur Ausbildung einer Schraubverbindung 220 auf. Ein zweiter Schenkel 300 weist eine kegelförmig zulaufende Öffnung 310 zur Ausbildung einer Schraubverbindung und einen abgeschrägten Anteil 320 auf.

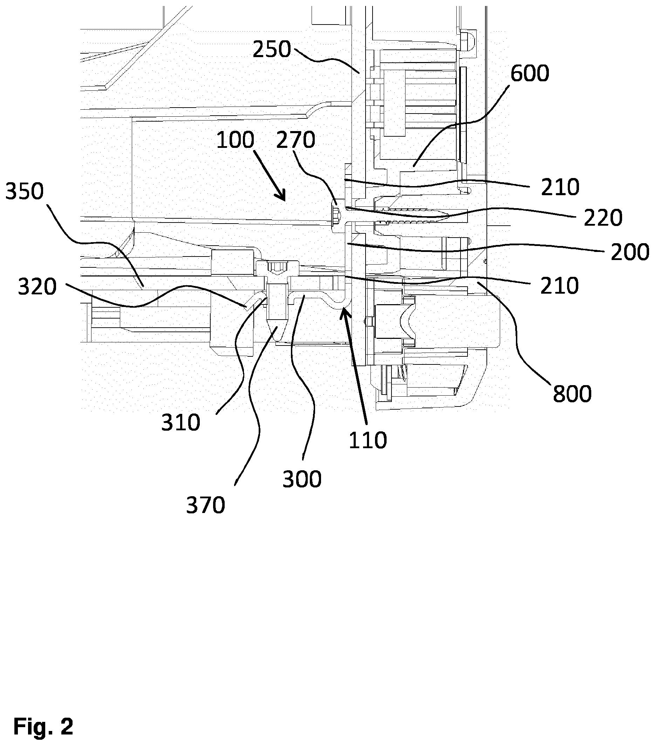

Figur 2 zeigt das gewinkelte und leitfähige Verbindungsmittel 100 mit einer beispielhaften besonders vorteilhaften Formgebung im Scheitelbereich 110 des Winkels in einer Schnittzeichnung in einem beispielhaften Verwendungsfall in einem Fahrzeug-Einbaugerät. Wie in diesem Ausführungsbeispiel für den ersten Schenkel 200 gezeigt, ist ein erster Schenkel 200 des Verbindungsmittels 100 mit einer in dieser Darstellung vertikalen Platine 250 zur Verbindung gebracht. Der erste Schenkel 200 weist Ausnehmungen zur Ausbildung von Lötverbindungen 210 auf und eine Ausnehmung zur Ausbildung einer Schraubverbindung 220, durch die in diesem beispielhaften Fall eine Schraube 270 hindurch, durch einen weiteren Körper 600, der mit einer Ausformung teilweise in eine Ausnehmung in der Platine 250 hinein ragt, hindurch in einen dritten Körper 800, der eine Frontblende des Fahrzeugeinbaugerätes bildet, geschraubt ist. Weiterhin weist der zweite Schenkel 300 eine kegelförmig zulaufende Öffnung 310 zur Ausbildung einer Schraubverbindung mit einer Schraube 370 und einen abgeschrägten Anteil 320 auf. In diesem Ausführungsbeispiel befindet sich die erste Platine 250 auf der Außenseite des ersten Schenkels 200 des Verbindungsmittels 100 und die zweite Platine 350 auf der Innenseite des zweiten Schenkels 300 des Verbindungsmittels 100. Die Platine 250 ist mittels Löten mit dem ersten Schenkel 200 des Verbindungsmittels 100 verbunden. In den Ausnehmungen 210 kann beim Ausbilden der Lötverbindung eingebrachtes Lötzinn aufsteigen und Lot-Menisken ausformen.

Weiterhin ist eine Schraube 270 durch eine Ausnehmung in dem Verbindungsmittel 100, durch eine Ausnehmung in der ersten Platine 250, durch eine Ausnehmung im zweiten Körper 600 hindurch in den dritten Körper 800 geschraubt. Der dritte Körper 800 weist einen Führungszapfen 810 zur Ausbildung der Schraubverbindung auf. Die zweite Platine 350 ist mit der zweiten Schraube 370 an den zweiten Schenkel 300 des Verbindungsmittels 100 verschraubt. Dabei weist die Schraube 370 ein selbstfurchendes Gewinde auf, mit dem sie beim Ausbilden der Schraubverbindung ein Gewinde in der Wand der Kegelförmigen Ausnehmung 310 des zweiten Schenkels 300 furcht. In dem gezeigten Ausführungsbeispiel weist das Verbindungsmittel 100 einen Winkel von 90° auf.

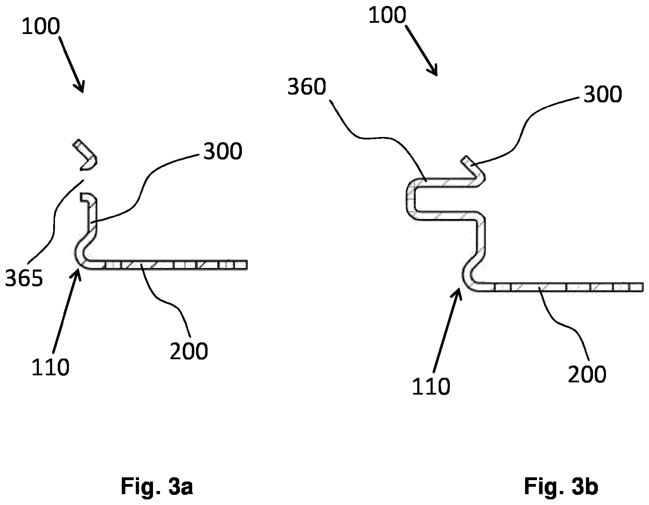

Figur 3 zeigt, unterteilt in Teilfiguren Figur 3a und Figur 3b, das gewinkelte und leitfähige Verbindungsmittel 100 mit jeweils beispielhafter besonders vorteilhafter Formgebung als Schnittzeichnungen. Hierbei zeigt Figur 3a das gewinkelte Verbindungsmittel 100 in einer Variante mit einer Ausnehmung 365 zur Ausbildung einer Schraubverbindung mit einer Schraube 370 (nicht gezeigt), womit der Schenkel 300 des gewinkelten Verbindungsmittels 100 mit der an diesem Schenkel 300 angeordneten Platine 350 (nicht gezeigt) verschraubbar ist. Figur 3b zeigt das gewinkelte Verbindungsmittel 100 in einer Variante mit einer aus der Ebene des Schenkels 300 herausragenden hohlen Ausformung 360 oder Ausstülpung 360 derart, dass das Material des Verbindungsmittels 100 das leere Volumen der hohlen Ausformung 360 oder Ausstülpung 360 als Wandung umgibt. Dabei ist die Ausformung 360 oder Ausstülpung 360 zur Ausbildung einer Schraubverbindung so gestaltet, dass sie eine Schraube 370 (nicht gezeigt) aufnimmt, mit der das gewinkelte Verbindungsmittel 100 mit der Platine 350 verschraubbar ist. In der in Figur 3b gezeigten Variante ist die Ausformung 360 oder Ausstülpung 360 im Wesentlichen zylinderförmig gestaltet. Die Gestaltung der Ausstülpung 360 oder Ausformung 360 ist so mit der Größe einer Schraube 370 (nicht gezeigt) abgestimmt, dass nach dem Verschrauben die Ausstülpung 360 oder Ausformung 360 die Schraube 370 (nicht gezeigt) so umgibt, dass die Schraube 370 dort durch die Ausstülpung 360 oder Ausformung 360 gekapselt ist. In der Folge verhindert die Ausstülpung 360 oder Ausformung 360 das Austreten eventuell beim Verschrauben entstehender Späne aus dem Volumen, das von der Ausstülpung 360 oder Ausformung 360 begrenzt ist.

Mit einem gewinkelten und leitfähigen Verbindungsmittel 100 wird eine elektrischen Verbindung oder galvanischen Brücke von zumindest zwei Platinen 250, 350 und zugleich eine mechanische Verbindung dieser Platinen für ein elektrisches oder elektronisches Gerät ausgebildet.

In einer Variante der Baugruppe bestehend aus zumindest zwei Platinen 250; 350 und zumindest einem gewinkelten und leitfähigen Verbindungsmittel 100 stellt das gewinkelte Verbindungsmittel 100 zusätzlich eine Positionierung der Platinen relativ zueinander und eine Fixierung der sich so ergebenden Positionen her, wie es beispielhaft in Figur 2 gezeigt ist.

In einer Variante der Baugruppe bestehend aus zumindest zwei Platinen 250; 350 und zumindest einem gewinkelten und leitfähigen Verbindungsmittel 100 besteht das gewinkelte Verbindungsmittel 100 aus einem metallischen Material, vorzugsweise aus Stahl wie es beispielhaft in Figur 2 gezeigt ist.

In einer Variante der Baugruppe bestehend aus zumindest zwei Platinen 250; 350 und zumindest einem gewinkelten und leitfähigen Verbindungsmittel 100 ist das gewinkelte Verbindungsmittel 100 so ausgeführt, dass die Platinen in einem Winkel von 90° zueinander angeordnet sind, wie es beispielhaft in Figur 2 gezeigt ist.

In einer Variante der Baugruppe bestehend aus zumindest zwei Platinen 250; 350 und zumindest einem gewinkelten und leitfähigen Verbindungsmittel 100 ist das gewinkelte Verbindungsmittel 100 mittels einer Lötverbindung mit der an diesem Schenkel angeordneten Platine verbunden, wie in dem Ausführungsbeispiel in Figur 2 für den ersten Schenkel 200 gezeigt.

In einer Variante der Baugruppe bestehend aus zumindest zwei Platinen 250; 350 und zumindest einem gewinkelten und leitfähigen Verbindungsmittel 100 ist das gewinkelte Verbindungsmittel 100 derart mittels einer Lötverbindung mit der an diesem Schenkel angeordneten Platine in Verbindung gebracht, dass der Schenkel zumindest eine Ausnehmung 210 aufweist, durch die in einem Lötvorgang eingebrachtes Lötzinn aufsteigen kann, wie in dem Ausführungsbeispiel in Figur 2 für den ersten Schenkel 200 gezeigt.

In einer Variante der Baugruppe bestehend aus zumindest zwei Platinen 250; 350 und zumindest einem gewinkelten und leitfähigen Verbindungsmittel 100 ist das gewinkelte Verbindungsmittel 100 mit der an diesem Schenkel angeordneten Platine verschraubt, wie in dem Ausführungsbeispiel in Figur 2 für den zweiten Schenkel 200 gezeigt.

In einer Variante der Baugruppe bestehend aus zumindest zwei Platinen 250; 350 und zumindest einem gewinkelten und leitfähigen Verbindungsmittel 100 ist die Formgebung des gewinkelten Verbindungsmittels 100 derart gestaltet, dass die an der Innenseite des einen Schenkels angeordnete Platine in den Scheitelpunkt des Winkels des Verbindungsmittels ragen kann, wie in dem Ausführungsbeispiel in Figur 2 für den zweiten Schenkel 200 gezeigt.

In einer Variante der Baugruppe bestehend aus zumindest zwei Platinen 250; 350 und zumindest einem gewinkelten und leitfähigen Verbindungsmittel 100 ist das gewinkelte Verbindungsmittel 100 derart gestaltet, dass die Schnittgerade der zwei Flächen, die auf den innenseitigen Oberflächen der beiden Schenkel des Verbindungsmittels liegen, außerhalb des Körpers des Verbindungsmittels liegt oder an der Außenseite der Oberfläche des Verbindungsmittels tangierend anliegt, wie es beispielhaft in Figur 2 gezeigt ist.

In einer Variante der Baugruppe bestehend aus zumindest zwei Platinen 250; 350 und zumindest einem gewinkelten und leitfähigen Verbindungsmittel 100 weist zumindest einer der Schenkel 200; 300 des gewinkelten Verbindungsmittels 100 zumindest eine kegelförmig zulaufende Öffnung 310 zur Aufnahme eines Gewindes einer Schraube auf, wie in dem Ausführungsbeispiel in Figur 2 für den zweiten Schenkel 200 gezeigt.

In einer Variante der Baugruppe bestehend aus zumindest zwei Platinen 250; 350 und zumindest einem gewinkelten und leitfähigen Verbindungsmittel 100 weist zumindest einer der Schenkel 200; 300 des gewinkelten Verbindungsmittels 100 an seinem dem Scheitelpunkt des Winkels fernen Ende einen gegenüber dem scheitelnahen Anteil abgeschrägten Anteil 320 auf, wie in dem Ausführungsbeispiel in Figur 2 für den zweiten Schenkel 200 gezeigt.

In einer Variante der Baugruppe bestehend aus zumindest zwei Platinen 250; 350 und zumindest einem gewinkelten und leitfähigen Verbindungsmittel 100 weist zumindest einer der Schenkel 200; 300 des gewinkelten Verbindungsmittels 100 an seinem dem Scheitelpunkt des Winkels fernen Ende einen derart gegenüber dem scheitelnahen Anteil abgeschrägten Anteil auf, dass der abgeschrägte Anteil 320 mit dem anderen Schenkel einen größeren Innenwinkel bildet, als der nicht abgeschrägte Anteil des Schenkels mit dem anderen Schenkel, wie in dem Ausführungsbeispiel in Figur 2 für den zweiten Schenkel 200 gezeigt.

In einer hier nicht dargestellten Variante der Baugruppe bestehend aus zumindest zwei Platinen 250; 350 und zumindest einem gewinkelten und leitfähigen Verbindungsmittel 100 ist das gewinkelte Verbindungsmittel 100 derart gestaltet, dass die Flächennormalen zumindest zweier Schenkel windschief sind.

In weiteren einer hier nicht dargestellten Variante der Baugruppe bestehend aus zumindest zwei Platinen 250; 350 und zumindest einem gewinkelten und leitfähigen Verbindungsmittel 100 weist das gewinkelte Verbindungsmittel 100 mehr als zwei Schenkel auf.

Eine Variante der Baugruppe bestehend aus zumindest zwei Platinen 250; 350 und zumindest einem gewinkelten und leitfähigen Verbindungsmittel 100 wird in einer Weise verwendet, neben der mittels des Verbindungsmittels ausgebildeten Verbindung von zumindest zwei Platinen zusätzlich mittels Platine-zu-Platine-Stecker ("board-to-board" - Stecker) eine Verbindung zwischen zumindest zwei der Platinen ausgebildet ist (nicht dargestellt).

Eine Variante einer Baugruppe bestehend aus zumindest zwei Platinen 250; 350 und zumindest einem gewinkelten und leitfähigen Verbindungsmittel ist Bestandteil eines Fahrzeugeinbaugerätes, wie es beispielhaft in Figur 2 gezeigt ist.

## Patentansprüche

1. Baugruppe bestehend aus zumindest zwei Platinen (250; 350) und zumindest einem gewinkelten und leitfähigen Verbindungsmittel (100) für ein elektrisches oder elektronisches Gerät, wobei das Verbindungsmittel eine elektrische Verbindung oder galvanische Brücke der zumindest zwei Platinen (250; 350) und zugleich eine mechanische Verbindung dieser Platinen (250; 350) in der Baugruppe ausbildet und wobei das Verbindungsmittel (100) zumindest zwei zueinander in einem Winkel stehende Schenkel (200; 300) aufweist und eine erste Platine (250) an der Außenseite eines ersten Schenkels (200) angeordnet ist und eine zweite Platine (350) an der Innenseite eines zweiten Schenkels (300) angeordnet ist und wobei der Winkel dieser zwei Platinen (250; 350) zueinander dem Winkel des ersten Schenkels (200) des Verbindungsmittels (100) zum zweiten Schenkel (300) des Verbindungsmittels (100) entspricht, **dadurch gekennzeichnet, dass** zumindest ein Schenkel (200; 300) des gewinkelten Verbindungsmittels (100) mittels einer Lötverbindung mit der an diesem Schenkel angeordneten Platine (250; 350) verbunden ist und zumindest ein Schenkel (200; 300) des gewinkelten Verbindungsmittels (100) mit der an diesem Schenkel angeordneten Platine (250; 350) verschraubt ist,
wobei das gewinkelte Verbindungsmittel (100) zusätzlich eine Positionierung der Platinen relativ zueinander und eine Fixierung der sich so ergebenden Positionen herstellt, und
dass die Formgebung des gewinkelten Verbindungsmittels (100) derart gestaltet ist, dass die an der Innenseite des einen Schenkels (300) angeordnete Platine (350) in den Scheitelpunkt des Winkels des Verbindungsmittels (100) ragt,
wobei ein Radius im Scheitelbereich (110) des Winkels des Verbindungsmittels (100) gegenüber der Ebene des Schenkels (300), an dessen Innenseite die Platine (350) angeordnet ist, nach außen versetzt ist, sodass bis zum Scheitelpunkt des Winkels Platz für die innenseitig angeordnete Platine (350) vorhanden ist.

2. Baugruppe nach einem der vorigen Ansprüche, wobei das gewinkelte Verbindungsmittel (100) aus einem metallischen Material, vorzugsweise aus Stahl, besteht.

3. Baugruppe nach einem der vorigen Ansprüche, wobei das gewinkelte Verbindungsmittel (100) so ausgeführt ist, dass die Platinen in einem Winkel von 90° zueinander angeordnet sind.

4. Baugruppe nach einem der vorigen Ansprüche, wobei dieser zumindest eine Schenkel (200; 300) des gewinkelten Verbindungsmittels (100) derart mittels einer Lötverbindung mit der an diesem Schenkel angeordneten Platine in Verbindung gebracht ist, dass der Schenkel zumindest eine Ausnehmung (210) aufweist, durch die in einem Lötvorgang eingebrachtes Lötzinn aufsteigen kann.

5. Baugruppe nach einem der vorigen Ansprüche, wobei das gewinkelte Verbindungsmittel (100) an zumindest einem Schenkel (200; 300) zumindest eine aus einer Ebene des Schenkels (200; 300) herausragende hohle Ausformung (360) oder Ausstülpung (360) derart aufweist, dass das Material des Verbindungsmittels (100) das leere Volumen der hohlen Ausformung (360) oder Ausstülpung (360) als Wandung umgibt, wobei die Ausformung (360) oder Ausstülpung (360) eine Schraube (370) aufnimmt, mit der das gewinkelte Verbindungsmittel (100) mit einer der Platinen (250; 350) verschraubt ist.

6. Baugruppe nach Anspruch 5, wobei die Ausformung (360) oder Ausstülpung (360) eine im Wesentlichen zylindrische oder konische Form aufweist oder von topfförmiger Gestalt ist.

7. Baugruppe nach einem der vorigen Ansprüche, wobei die Formgebung des gewinkelten Verbindungsmittels (100) derart gestaltet ist, dass die Schnittgerade der zwei Flächen, die auf den innenseitigen Oberflächen der beiden Schenkel des Verbindungsmittels liegen, außerhalb des Körpers des Verbindungsmittels liegt oder an der Außenseite der Oberfläche des Verbindungsmittels tangierend anliegt.

8. Baugruppe nach einem der vorigen Ansprüche, wobei zumindest einer der Schenkel (200; 300) des gewinkelten Verbindungsmittels (100) zumindest eine kegelförmig zulaufende Öffnung (310) zur Aufnahme eines Gewindes einer Schraube aufweist.

9. Baugruppe nach einem der vorigen Ansprüche, wobei zumindest einer der Schenkel (200; 300) des gewinkelten Verbindungsmittels (100) an seinem dem Scheitelpunkt des Winkels fernen Ende einen gegenüber dem scheitelnahen Anteil abgeschrägten Anteil (320) aufweist.

10. Baugruppe nach Anspruch 9, wobei der zumindest eine Schenkel (200; 300) des gewinkeltes Verbindungsmittels (100) an seinem dem Scheitelpunkt des Winkels fernen Ende derart einen abgeschrägten Anteil (320) aufweist, dass der abgeschrägte Anteil (320) mit dem anderen Schenkel einen größeren Innenwinkel bildet, als der nicht abgeschrägte Anteil des Schenkels mit dem anderen Schenkel.

11. Baugruppe nach einem der vorigen Ansprüche, wobei das gewinkelte Verbindungsmittel (100) so gestaltet ist, dass die Flächennormalen zumindest zweier Schenkel windschief sind.

12. Baugruppe nach einem der vorigen Ansprüche, wobei das gewinkelte Verbindungsmittel (100) mehr als zwei Schenkel aufweist.

13. Verwendung einer Baugruppe mit gewinkeltem Verbindungsmittel (100) nach einem der vorangehenden Ansprüche, wobei neben der mittels des Verbindungsmittels (100) ausgebildeten Verbindung von zumindest zwei Platinen (250; 350) zusätzlich mittels Platine-zu-Platine-Stecker eine Verbindung zwischen zumindest zwei der Platinen ausgebildet ist.

14. Fahrzeugeinbaugerät mit einer Baugruppe nach einem der Ansprüche 1 bis 12.

## Claims

1. An assembly consisting of at least two circuit boards (250; 350) and at least one angled and conductive connecting means (100) for an electric or electronic device, wherein the connecting means forms an electrical connection or galvanic bridge of the at least two circuit boards (250; 350) and at the same time forms a mechanical connection of these circuit boards (250; 350) in the assembly, and wherein the connecting means (100) has at least two legs (200; 300) arranged at an angle in relation to one another and a first circuit board (250) is arranged on the outer side of a first leg (200) and a second circuit board (350) is arranged on the inner side of a second leg (300), and wherein the angle of these two circuit boards (250; 350) in relation to one another corresponds to the angle between the first leg (200) of the connecting means (100) and the second leg (300) of the connecting means (100), **characterized in that** at least one leg (200; 300) of the angled connecting means (100) is connected by means of a soldered connection to the circuit board (250; 350) arranged on this leg, and at least one leg (200; 300) of the angled connecting means (100) is screwed to the circuit board (250; 350) arranged on this leg, wherein the angled connecting means (100) additionally establishes positioning of the circuit boards relative to one another and fixing of the thus resulting positions, and
**in that** the shaping of the angled connecting means (100) is designed such that the circuit board (350) arranged on the inner side of one leg (300) projects into the vertex of the angle of the connecting means (100),
wherein a radius in the vertex area (110) of the angle of the connecting means (100) is offset outward in relation to the plane of the leg (300), on the inside of which the circuit board (350) is arranged, such that, up to the vertex of the angle, there is space for the circuit board (350) arranged on the inside.

2. The assembly as claimed in any one of the preceding claims, wherein the angled connecting means (100) consists of a metallic material, preferably of steel.

3. The assembly as claimed in any one of the preceding claims, wherein the angled connecting means (100) is designed such that the circuit boards are arranged at an angle of 90° in relation to one another.

4. The assembly as claimed in any one of the preceding claims, wherein this at least one leg (200; 300) of the angled connecting means (100) is connected by means of a soldered connection to the circuit board arranged on this leg in such a way that the leg has at least one recess (210) through which soldering tin introduced in a soldering procedure can rise.

5. The assembly as claimed in any one of the preceding claims, wherein the angled connecting means (100) has, on at least one leg (200; 300), at least one hollow formation (360) or protuberance (360) which projects out of a plane of the leg (200; 300) such that the material of the connecting means (100) surrounds the empty volume of the hollow formation (360) or protuberance (360) as a wall, wherein the formation (360) or protuberance (360) receives a screw (370), using which the angled connecting means (100) is screwed to one of the circuit boards (250; 350).

6. The assembly as claimed in claim 5, wherein the formation (360) or protuberance (360) has a substantially cylindrical or conical shape or is of pot-shaped form.

7. The assembly as claimed in any one of the preceding claims, wherein the shaping of the angled connecting means (100) is designed such that the line of intersection of the two surfaces which lie on the inner-side surfaces of the two legs of the connecting means lies outside the body of the connecting means or bears tangentially against the outer side of the surface of the connecting means.

8. The assembly as claimed in any one of the preceding claims, wherein at least one of the legs (200; 300) of the angled connecting means (100) has at least one conically tapering opening (310) for receiving a thread of a screw.

9. The assembly as claimed in any one of the preceding claims, wherein at least one of the legs (200; 300) of the angled connecting means (100) has, at its end remote from the vertex of the angle, a part (320) which is bevelled in relation to the part close to the vertex.

10. The assembly as claimed in claim 9, wherein the at least one leg (200; 300) of the angled connecting means (100) has, at its end remote from the vertex of the angle, a bevelled part (320) in such a way that the bevelled part (320) forms a larger internal angle with the other leg than the non-bevelled part of the leg forms with the other leg.

11. The assembly as claimed in any one of the preceding claims, wherein the angled connecting means (100) is designed such that the surface normals of at least two legs are skew.

12. The assembly as claimed in any one of the preceding claims, wherein the angled connecting means (100) has more than two legs.

13. A use of an assembly having angled connecting means (100) as claimed in any one of the preceding claims, wherein, in addition to the connection of at least two circuit boards (250; 350) formed by means of the connecting means (100), a connection is additionally formed between at least two of the circuit boards by means of a circuit board-to-circuit board connector.

14. A vehicle installation device having an assembly as claimed in any one of claims 1 to 12.

## Revendications

1. Ensemble comportant au moins deux platines (250 ; 350) et au moins un dispositif de fixation conducteur présentant un angle (100) pour un dispositif électrique ou électronique, dans lequel le dispositif de fixation forme une liaison électrique ou un pont galvanique entre les au moins deux platines (250 ; 350) et en même temps une liaison mécanique entre les platines (250 ; 350) dans l'ensemble, et dans lequel le dispositif de fixation (100) présente au moins deux branches (200 ; 300) disposées en angle l'une par rapport à l'autre, et une première platine (250) est disposée sur la face extérieure d'une première branche (200) et une seconde platine (350) est disposée sur la face intérieure d'une seconde branche (300), et dans lequel l'angle des deux platines (250 ; 350) correspond à l'angle de la première branche (200) du dispositif de fixation (100) et de la seconde branche (300) du dispositif de fixation (100) l'une par rapport à l'autre, **caractérisé en ce qu'**au moins une branche (200 ; 300) du dispositif de fixation présentant un angle (100) est reliée par une soudure à la platine (250 ; 350) disposée sur la branche et qu'au moins une branche (200 ; 300) du dispositif de fixation présentant un angle (100) est vissée à la platine (250 ; 350) disposée sur la branche,
dans lequel le dispositif de fixation présentant un angle (100) établit en outre un positionnement des platines l'une par rapport à l'autre et une fixation des positions obtenues, et
**en ce que** la forme du dispositif de fixation présentant un angle (100) est configurée de sorte que la platine (350) disposée sur la face intérieure d'une branche (300) dépasse au sommet de l'angle du dispositif de fixation (100),
dans lequel un rayon dans la région du sommet (110) de l'angle du dispositif de fixation (100) est décalé vers l'extérieur par rapport au plan de la branche (300) sur la face intérieure de laquelle la platine (350) est disposée, de sorte qu'il y a de la place pour la platine (350) disposée sur la face intérieure jusqu'au sommet de l'angle.

2. Ensemble selon l'une des revendications précédentes, dans lequel le dispositif de fixation présentant un angle (100) est constitué d'un matériau métallique, de préférence d'acier.

3. Ensemble selon l'une des revendications précédentes, dans lequel le dispositif de fixation présentant un angle (100) est conçu de sorte que les platines sont disposées à un angle de 90° l'une par rapport à l'autre.

4. Ensemble selon l'une des revendications précédentes, dans lequel l'au moins une branche (200 ; 300) du dispositif de fixation présentant un angle (100) est reliée par une soudure à la platine disposée sur la branche, de sorte que la branche présente au moins un évidement (210) à travers lequel la soudure introduite lors d'un processus de soudure peut remonter.

5. Ensemble selon l'une des revendications précédentes, dans lequel le dispositif de fixation présentant un angle (100) sur au moins une branche (200 ; 300) présente au moins une forme creuse (360) ou une protubérance (360) dépassant d'un plan de la branche (200 ; 300), de sorte que le matériau du dispositif de fixation (100) entoure le volume vide de la forme creuse (360) ou de la protubérance (360) comme une paroi, dans lequel la forme (360) ou la protubérance (360) permet d'accueillir une vis (370), à l'aide de laquelle le dispositif de fixation présentant un angle (100) est vissé à l'une des platines (250 ; 350).

6. Ensemble selon la revendication 5, dans lequel la forme (360) ou la protubérance (360) présente une forme essentiellement cylindrique ou conique ou a une forme de pot.

7. Ensemble selon l'une des revendications précédentes, dans lequel la forme du dispositif de fixation présentant un angle (100) est configurée de sorte que la ligne de coupe des deux surfaces reposant sur les surfaces des faces intérieures des deux branches du dispositif de fixation se trouve à l'extérieur du corps du dispositif de fixation ou repose de manière tangentielle sur la face extérieure de la surface du dispositif de fixation.

8. Ensemble selon l'une des revendications précédentes, dans lequel au moins l'une des branches (200 ; 300) du dispositif de fixation présentant un angle (100) présente au moins une ouverture se rétrécissant en forme de cône (310) pour recevoir un filetage d'une vis.

9. Ensemble selon l'une des revendications précédentes, dans lequel au moins l'une des branches (200 ; 300) du dispositif de fixation présentant un angle (100) présente à son extrémité opposée au sommet de l'angle une partie (320) biseautée par rapport à la partie proche du sommet.

10. Ensemble selon la revendication 9, dans lequel l'au moins une branche (200 ; 300) du dispositif de fixation présentant un angle (100) présente à son extrémité opposée au sommet de l'angle une partie biseautée (320), de sorte que la partie biseautée (320) forme avec l'autre branche un angle interne plus grand que la partie non biseautée de la branche avec l'autre branche.

11. Ensemble selon l'une des revendications précédentes, dans lequel le dispositif de fixation présentant un angle (100) est configuré de sorte que les normales de surface d'au moins deux branches sont obliques.

12. Ensemble selon l'une des revendications précédentes, dans lequel le dispositif de fixation présentant un angle (100) présente plus de deux branches.

13. Utilisation d'un ensemble avec dispositif de fixation présentant un angle (100) selon l'une des revendications précédentes, dans lequel, en plus de la liaison d'au moins deux platines (250 ; 350) formées par le dispositif de fixation (100), une liaison est en outre formée entre au moins deux des platines par un connecteur platine à platine.

14. Dispositif monté sur véhicule comprenant un ensemble selon l'une des revendications 1 à 12.
